# EUROPEAN PATENT APPLICATION

(11) **EP 4 411 824 A1**
(43) Date of publication of application: **07.08.2024**
(21) Application number: 24153277.9
(22) Date of filing: 22.01.2024
(51) Int. Cl.: H01L 29/10, H01L 29/66, H01L 29/74, H01L 29/06

(54) **METHOD OF PEAK ON-STATE VOLTAGE REDUCTION FOR THYRISTOR SEMICONDUCTOR DEVICE FABRICATION**

(30) Priority: 30.01.2023 CN 202310067732
(71) Applicant: Littelfuse Semiconductor (Wuxi) Co., Ltd., Wuxi, Jiangsu 214142 (CN)
(72) Inventor: GU, Xingchong, Wuxi, 214142 (US); ZHOU, Jifeng, Wuxi, 214142 (US)
(74) Representative: Arnold & Siedsma

(57) **Abstract**

Techniques for reducing peak on-state voltage of a thyristor semiconductor device fabricated in a wafer. A substrate layer (112) is provided. An isolation structure (122) is provided to laterally isolate the semiconductor device from other semiconductor devices in the wafer. A p-type tub structure (132) is formed in the substrate layer. A p-type base layer (142) is provided such that the base layer is disposed under the substrate layer. The base layer includes an anode (214) having an associated active region that includes an n-type drift region (225) in the substrate layer. The tub structure is disposed inside the active region such that presence of the tub structure reduces a thickness (226) of the drift region (225). The device further comprises insulation trenches / moats (214).

## Description

### BACKGROUND

Embodiments presented in this disclosure relate to the field of semiconductor devices. More specifically, embodiments disclosed herein relate to techniques for peak on-stage voltage reduction for semiconductor device fabrication.

Semiconductor devices are widely used in control of electric power, ranging from light dimmers electric motor speed control to high-voltage direct current power transmission. For instance, thyristors are used for alternating current (AC) power control applications. Thyristors can operate as an electric power switch because the thyristors are characterized by an ability to rapidly switch from a state of non-conductivity to a state of conductivity. In operation, thyristors turn on, switching from a high-impedance state to a low-impedance state. This is done by applying a voltage between a gate and a cathode and running current from the gate to the cathode.

### SUMMARY

One embodiment presented in this disclosure provides a method of fabricating a semiconductor device in a wafer. The method includes providing a substrate layer. The method also includes providing an isolation structure that laterally isolates the semiconductor device from other semiconductor devices in the wafer. The method also includes forming a tub structure in the substrate layer. The method also includes providing a base layer disposed under the substrate layer. The base layer includes an anode having an associated active region that includes a drift region in the substrate layer. The tub structure is disposed inside the active region such that the presence of the tub structure reduces a thickness of the drift region.

Another embodiment provides a wafer for fabricating semiconductor devices. The wafer includes an isolation structure that laterally isolates the semiconductor devices from one another in the wafer. The wafer also includes a substrate layer for each of the semiconductor devices. The wafer also includes a tub structure for each semiconductor device. The tub structure is formed in the substrate layer. The wafer also includes, for each semiconductor device, a lower base layer disposed below the substrate layer and the tub structure. The lower base layer includes an anode having an associated active region that includes a drift region in the substrate layer. The tub structure is disposed inside the active region such that presence of the tub structure reduces a thickness of the drift region. The wafer also includes an upper base layer disposed above the substrate layer. The wafer also includes a top layer disposed above the upper base layer.

Still another embodiment provides a semiconductor device fabricated in a wafer. The semiconductor device includes a substrate layer. The semiconductor device also includes a tub structure formed in the substrate layer. The semiconductor device also includes a lower base layer disposed below the substrate layer and the tub structure. The lower base layer includes an anode having an associated active region that includes a drift region in the substrate layer. The tub structure is disposed inside the active region such that the tub structure reduces a thickness of the drift region. The semiconductor device also includes an upper base layer disposed above the substrate layer. The semiconductor device also includes a top layer disposed above the upper base layer.

### BRIEF DESCRIPTION OF THE DRAWINGS

Figure 1 depicts cross-sectional views of a portion of a wafer during different stages of a fabrication process for peak on-state voltage reduction, according to one embodiment presented in this disclosure.
Figure 2 depicts a cross-sectional view of the portion of the wafer during a subsequent stage of the fabrication process for peak on-state voltage reduction of a semiconductor device of a first type, according to one embodiment presented in this disclosure.
Figure 3 depicts a plan view of the wafer during the subsequent stage of the fabrication process for peak on-state voltage reduction of the semiconductor device of the first type, according to one embodiment presented in this disclosure.
Figure 4 depicts a cross-sectional view of the portion of the wafer during a subsequent stage of the fabrication process for peak on-state voltage reduction of a semiconductor device of a second type, according to one embodiment presented in this disclosure.
Figure 5 depicts a plan view of the wafer during the subsequent stage of the fabrication process for peak on-state voltage reduction of the semiconductor device of the second type, according to one embodiment presented in this disclosure.
Figure 6 is a flowchart depicting a method for peak on-state voltage reduction for semiconductor device fabrication, according to one embodiment presented in this disclosure.

### DETAILED DESCRIPTION

Embodiments presented in this disclosure provide techniques for peak on-state voltage reduction for semiconductor device fabrication including power switching device fabrication. One embodiment includes forming a tub structure in a wafer by doping a substrate layer of the wafer. Doing so reduces a thickness of a drift region inside a portion of the substrate layer that corresponds to an anode active region of the semiconductor device. Further, reducing the thickness of the drift region can reduce a peak on-state voltage of the semiconductor devices fabricated in the wafer. Moreover, the peak on-state voltage can be reduced without impairing a capability of voltage blocking via an isolation structure of the semiconductor device when the semiconductor device is in a state of reverse bias. The capability of voltage blocking is maintained because although the tub structure is formed in the substrate layer, a sufficient amount of substrate remains in the substrate layer to serve as a depletion region when the semiconductor device is in the state of reverse bias. Advantageously, semiconductor devices having a reduced peak on-state voltage can thereby be fabricated.

Although embodiments are described herein with reference to particular examples of a specific type of semiconductor device for sakes of illustration and explanation, such is not intended to be limiting of the scope of disclosed embodiments. The specific type constitutes a thyristor, a known device based on four different semiconductor layers arranged in electrical series and generally formed within a monocrystalline substrate such as silicon. The thyristor includes four layers of materials of alternating types of alternating polarity type, positive (P) or negative (N), where the layers are arranged between an anode and a cathode. Those skilled in the art will recognize that more generally, other types of power switching devices and semiconductor devices can be fabricated using the techniques disclosed herein.

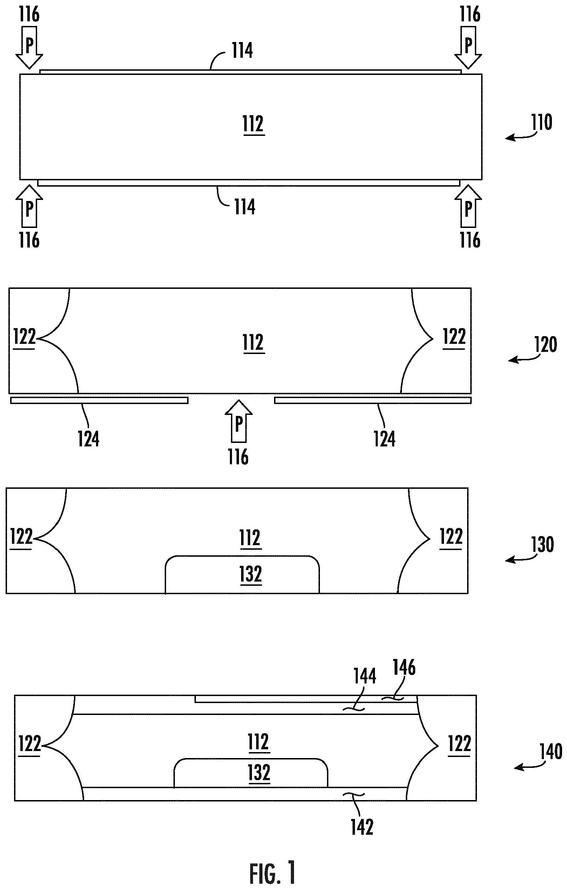

Figure 1 depicts cross-sectional views of a portion of a wafer during different stages of a fabrication process for peak on-state voltage reduction, according to one embodiment. The portion pertains to just one of multiple semiconductor devices to be fabricated in the wafer. The cross-sectional views correspond to vertical cross sections of the wafer, that is, cross sections that are perpendicular to a face of the wafer. As shown, at a first stage of the fabrication process, a wafer 110 includes a substrate layer 112, where the substrate layer 112 includes silicon. Both of the top and bottom surfaces of the substrate layer 112 are doped using a doping agent 116 and a doping mask 114. As used herein, a top surface is also referred to as an upper surface or front surface, while a bottom surface is also referred to as a lower surface or rear surface. The doping mask 114 includes oxide, according to one embodiment.

In the case of the substrate layer 112 being an N⁻ substrate layer, the doping agent 116 used is a P doping agent. An example of a P doping agent is boron, while an example of an N doping agent is phosphorous. As used herein with reference to doping agents, signs in superscript or the lack thereof represents relative doping concentrations, where a plus sign represents a higher relative doping concentration, a minus sign represents a lower relative doping concentration, and the lack of a sign represents a medium relative doping concentration. The signs are usable herein, even when the signs are not in superscript, interchangeably with the same signs in superscript. Multiple plus signs or minus signs in a row can be used to denote successively higher or lower relative doping concentrations.

Doping the substrate layer 112 of the wafer 110 using the doping agent 116 produces a wafer 120 having an isolation structure 122 at a second stage of the fabrication process, according to one embodiment. The isolation structure laterally isolates semiconductor devices from one another in the wafer. In the case of the P doping agent being used, the isolation structure is a P isolation structure. Generally, the isolation structure 122 is formed once the doping agent 116 diffused from the top surface and the bottom surface of the wafer 120 meet. Put another way, to form the isolation structure 122, each of the top and bottom surfaces of the substrate layer 112 is doped using the doping agent 116 until the diffused doping agent from the top surface meets the diffused doping agent from the bottom surface. The point at which the diffused doping agent meets can generally be proximate to a vertical center of the wafer 110 in terms of a thickness of the wafer 110.

The bottom surface of the substrate layer 112 of the wafer 120 can be doped using the doping agent 116 to produce a wafer 130 having a tub structure 132. In the case of the N⁻ substrate layer, the tub structure 132 is a P tub structure. The nomenclature of "tub" in the tub structure 132 refers to a shape of the tub structure 132 in the vertical cross section of the wafer bearing resemblance to a shape of a tub in a vertical cross section of the tub. The nomenclature should not be taken to denote or connote that the tub structure 132 takes on other physical characteristics of a tub, such as having a recessed interior of the tub that is visible in a plan view of the tub. Instead, at least in some embodiments, the tub structure 132 has a top surface that is substantially flat across an entirety of the top surface. As such, the top surface resembles that of a block rather than that of a tub, in such embodiments. Accordingly, the tub structure 132 can also be referred to as a block structure.

Next, both of the top and bottom surfaces of the substrate layer 112 of the wafer 130 can be further doped using the doping agent 116 to produce a wafer 140 having a lower base layer 142 and an upper base layer 144. In the case of the P doping agent being used, the lower base layer 142 is a P lower base layer, and the upper base layer is a P upper base layer. The upper base layer 144 can then be doped using a different doping agent. Doping the upper base layer 144 produces a top layer 146. In the case of the N⁻ substrate layer, this doping agent is an N⁺ doping agent, and the top layer 146 is an N⁺ top layer.

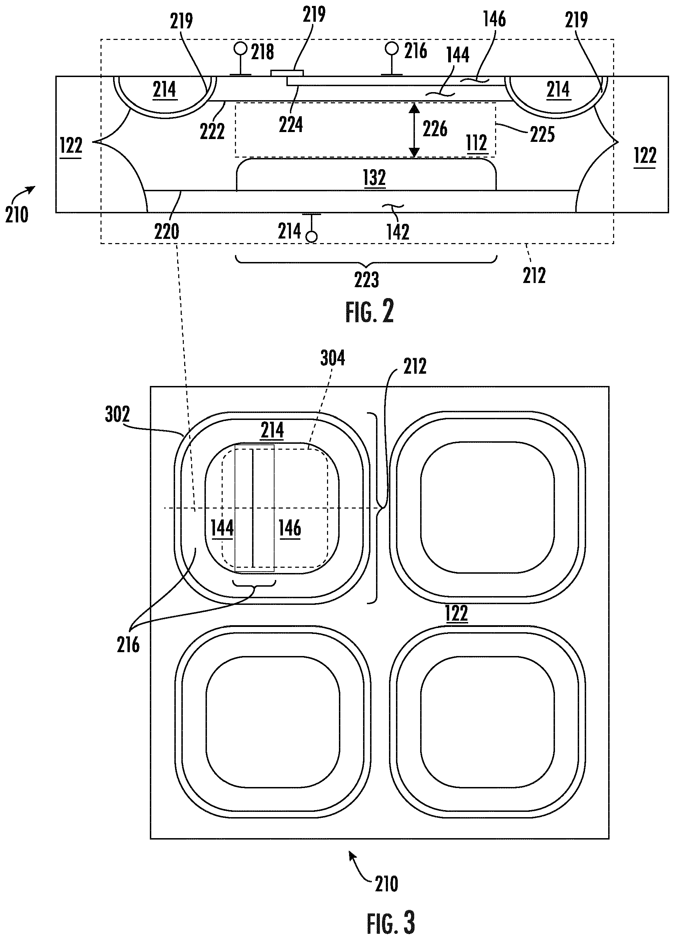

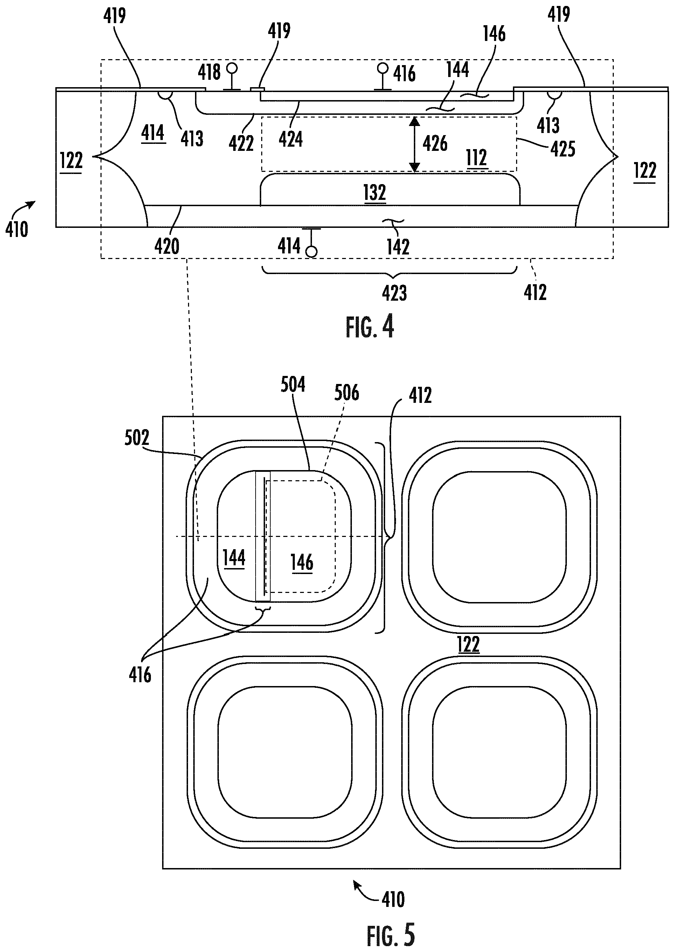

The wafer 140 can undergo additional stages of fabrication that depend on the type of the semiconductor device being fabricated. A wafer resulting from such additional stages of fabrication in the case of the semiconductor device being a thyristor of a first type is shown in Figure 2. In contrast, a wafer resulting from such additional stages of fabrication of a wafer comparable to the wafer 140 in the case of the semiconductor device being a thyristor of a second type is shown in Figure 4. In one embodiment, this wafer is distinct from the wafer 140 but is otherwise comparable therewith. For instance, the former has an upper base layer that is connected with the isolation structure, whereas the latter has an upper base layer that is patterned. For sakes of illustration and explanation, the effect of having the tub structure 132 in the wafer 140 is described in conjunction with the thyristors of these first and second types.

Although embodiments are described herein with reference to an N⁻substrate layer for sakes of illustration and explanation, such is not intended to be limiting of the scope of disclosed embodiments. For instance, by inverting the respective polarity of each doping agent disclosed herein, the techniques disclosed herein are applicable to the alternative use-case of a P⁻ substrate layer. It can suffice that the upper and lower base layers and the isolation structure are of a polarity type that is the inverse of a polarity type of the substrate and top layers.

Figure 2 depicts a cross-sectional view of the portion of the wafer during one such additional stage of the fabrication process, that is subsequent to the stages represented in Figure 1, according to one embodiment. The cross-sectional view corresponds to a vertical cross section of the wafer 210, where the vertical cross section is represented by a dotted line in the plan view of Figure 3.

In some embodiments, after the top layer 146 is produced, a moat 214 is formed for each semiconductor device in the wafer 210. More specifically, the moat 214 can be characterized as being formed around the upper base layer 144 of each semiconductor device based on the plan view of the wafer. As such, the moat 214 circumscribes the upper base layer 144 based on the plan view of the wafer. The moat 214 can be formed via an etching process such as a silicon etching process.

Further, the moat 214 partially exposes each of the substrate layer 112, the upper base layer 144, the top layer 146, and the isolation structure 122. Moreover, the substrate layer 112 is exposed only via the moat 214. On the other hand, at least in some embodiments, the moat 214 does not expose any of the lower base layer 142. Because the moat 214 has a cylindrical shape in the wafer 210, the moat 214 has a shape of a half-circle based on the cross-sectional view of the wafer 210, according to one embodiment. The upper base layer 144, however, need not necessarily be exposed by the moat 214, depending on the type of semiconductor device to be fabricated in the wafer. In certain alternative embodiments, the upper base layer 144 is not at all exposed via the moat 214.

After forming the moat 214, a passivation, represented as coating 216, is formed atop one or more coating regions on the top surface of the wafer 210. The one or more coating regions can include a respective one or more coating regions of each semiconductor device in the wafer 210. In a particular embodiment, the respective one or more coating regions include the moat 214 itself and one or more additional regions in an area circumscribed by the moat 214 based on the plan view of the wafer. The passivation constitutes a respective coating atop each of the coating regions. Depending on the embodiment, the passivation can include glass passivation or film passivation. For instance, the glass passivation can include electrical glass, whereas the film passivation can include oxide, silicon nitride, semi-insulating polycrystalline silicon (SIPOS), or tetraethyl orthosilicate.

As shown, the semiconductor device in the wafer 210 is a thyristor 212 of a type characterized as an isolation single-side mesa type. The thyristor 212 has terminals including an anode 214, a cathode 216, and a gate 218. The anode 214 is formed on the lower base layer 142, the cathode 216 is formed on the top layer 146, and the gate 218 is formed on the upper base layer 144. Further, each of the lower base layer 142 and the top layer 146 constitutes a respective emitter layer of the thyristor 212. That the lower base layer 142 constitutes an emitter layer can be the case for certain types of thyristors, such as silicon controlled rectifiers (SCRs). For certain other types of thyristors, such as alternating current (TRIACs), the lower base layer does not constitute any emitter layer.

Moreover, the thyristor 212 has P-N junctions including a first junction J1 220, a second junction J2 222, and a third junction J3 224. The first junction J1 220 is disposed between the lower base layer 142 and the substrate layer 112. The second junction J2 222 is disposed between the substrate layer 112 and the upper base layer 144. The third junction J3 224 is disposed between the upper base layer 144 and the top layer 146.

Advantageously, forming the tub structure 132 in the thyristor 212 reduces a thickness 226 of a drift region 225 in a portion of the substrate layer 112 that corresponds to an active region 223 associated with the anode 214 of the thyristor 212. Further, reducing the thickness 226 of the drift region 225 can reduce a peak on-state voltage, or V_{TM}, of the thyristor 212. At least in some embodiments, the peak on-state voltage characterizes a voltage drop across the main terminals of the thyristor 212 when the thyristor is operating in an "on" state. Moreover, the peak on-state voltage can be reduced without impairing a capability of voltage blocking via the isolation structure 122 of the thyristor 212. The capability of voltage blocking is maintained because although the tub structure 132 is formed in the substrate layer 112, a sufficient amount of substrate remains in the substrate layer 112 to serve as a depletion region when the thyristor 212 is in a state of reverse bias during operation.

Figure 3 depicts the plan view of the wafer 210 during the subsequent stage of the fabrication process of the thyristor 212 of the isolation single-side mesa type, according to one embodiment. The plan view is from a perspective of looking downward at the top surface of the wafer 210. Further, the plan view is of a portion of the wafer 210 that is greater in size than the portion depicted in Figure 1. In particular, the portion shown in the plan view includes four thyristors, one of which is the thyristor 212. That is, the plan view is of a portion that is approximately four times the size of the portion depicted in Figure 1 or 2.

Each of the four thyristors is isolated from one another in the wafer 210 via the isolation structure 122. The isolation structure 122 includes a boundary 302 around each thyristor. As shown, the boundary 302 is proximate to an outer boundary of the moat 214. In some embodiments, the boundary 302 and the outer boundary of the moat 214 overlap.

As shown, the plan view includes the top layer 146 of the thyristor 212, the upper base layer 144 of the thyristor 212, and the moat 214 of the thyristor 212. Each of the interior and exterior shapes of the moat 214 is characterized by a shape of a square with rounded corners, according to one embodiment. The coating 216 is formed both atop the moat 214 and atop a region where the upper base layer 144 meets the top layer 146 based on the plan view. The plan view includes a representation 304 of a shape of the tub structure inside the wafer 210. Because the tub structure itself is not visible on the top surface of the wafer 210, the representation 304 is shown in lieu of the tub structure.

Figure 4 depicts a cross-sectional view of the portion of the wafer during another such additional stage of the fabrication process, that is subsequent to the stages represented in Figure 1 and that is alternative to the additional stage represented in Figure 2, according to one embodiment. The cross-sectional view corresponds to a vertical cross section of the wafer 410, where the vertical cross section is represented by a dotted line in the plan view of Figure 5.

In some embodiments, after the top layer 146 is produced, one or more channel stoppers 414 are formed in the substrate layer 112 for each semiconductor device in the wafer 410. The one or more channel stoppers 414 reduces a measure of current leakage by serving as a depletion region in the substrate layer 112. A passivation, represented as coating 416, is formed atop one or more coating regions on the top surface of the wafer 410. The one or more coating regions can include a respective one or more coating regions of each semiconductor device in the wafer 410.

In a particular embodiment, the respective one or more coating regions include a region that circumscribes a boundary 504 of a combination of the upper base layer 144 and the top layer 146, where the region is itself circumscribed by the isolation structure 122. The respective one or more coating regions can include one or more additional regions in an area circumscribed by the boundary 504. The passivation constitutes a respective coating atop each of the coating regions, and the passivation can include glass passivation or film passivation.

As shown, the semiconductor device in the wafer 410 is a thyristor 412 of a type characterized as an isolation planar type. The thyristor 412 has terminals including an anode 414, a cathode 416, and a gate 418. The anode 414 is formed on the lower base layer 142, the cathode 416 is formed on the top layer 146, and the gate 418 is formed on the upper base layer 144. Further, each of the lower base layer 142 and the top layer 146 constitutes a respective emitter layer of the thyristor 412. Moreover, the thyristor 412 has P-N junctions including a first junction J1 420, a second junction J2 422, and a third junction J3 424.

Advantageously, forming the tub structure 132 in the thyristor 412 reduces a thickness 426 of a drift region 416 in a portion of the substrate layer 112 that corresponds to an active region 423 associated with the anode 414 of the thyristor 412. Further, reducing the thickness 426 of the drift region can reduce a peak on-state voltage, or V_{TM}, of the thyristor 212. In this regard, the peak on-state voltage can be reduced without impairing a capability of voltage blocking via the isolation structure 122 of the thyristor 412. The capability of voltage blocking is maintained because although the tub structure 132 is formed in the substrate layer 112, a sufficient amount of substrate remains in the substrate layer 112 to serve as a depletion region when the thyristor 412 is in a state of reverse bias during operation.

Figure 5 depicts the plan view of the wafer 410 during the subsequent stage of the fabrication process of the thyristor 412 of the isolation planar type, according to one embodiment. The plan view is from a perspective of looking downward at the top surface of the wafer 410. Further, the plan view is of a portion of the wafer 410 that is greater in size than the portion depicted in Figure 1. In particular, the portion shown in the plan view includes four thyristors, one of which is the thyristor 412. That is, the plan view is of a portion that is approximately four times the size of the portion depicted in Figure 1 or 4. Each of the four thyristors is isolated from one another in the wafer 410 via the isolation structure 122. The isolation structure 122 includes a boundary 502 around each thyristor.

As shown, the plan view includes the top layer 146 of the thyristor 412 and the upper base layer 144 of the thyristor 412. The coating 416 is formed in a region circumscribing a boundary 504 of a combination of the upper base layer 144 and the top layer 146. The region itself is circumscribed by the isolation structure 122. In addition, the coating 416 is formed atop a region where the upper base layer 144 meets the top layer 146 based on the plan view. The plan view includes a representation 506 of a shape of the tub structure inside the wafer 410. Because the tub structure itself is not visible on the top surface of the wafer 410, the representation 506 is shown in lieu of the tub structure.

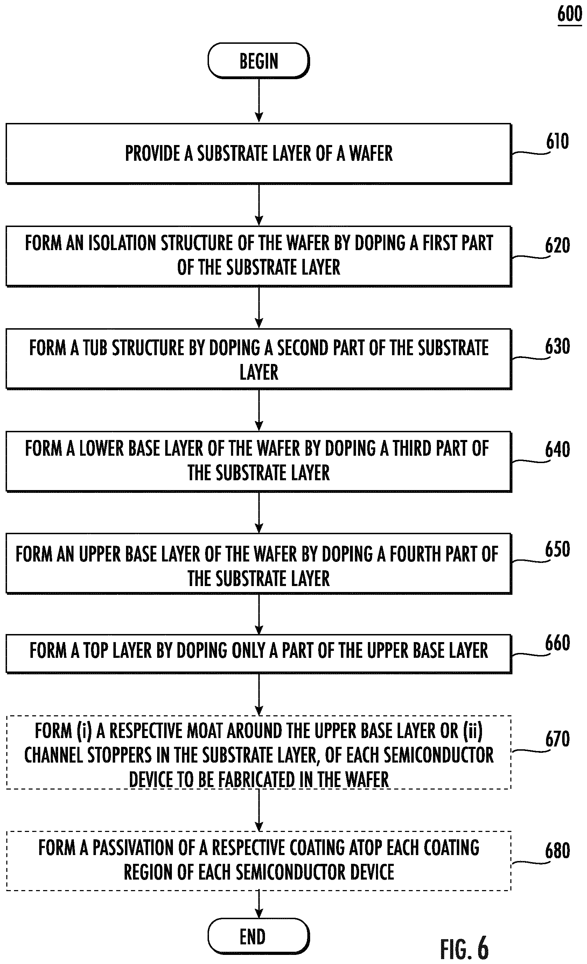

Figure 6 is a flowchart depicting a method 600 for peak on-state voltage reduction for semiconductor device fabrication, according to one embodiment. As shown, the method 600 begins at step 610, where a substrate layer of a wafer is provided. At step 620, an isolation structure is formed in the wafer by doping a first part of the substrate layer. At step 630, a tub structure is formed by doping a second part of the substrate layer. At step 640, a lower base layer of the wafer is formed by doping a third part of the substrate layer. At step 650, an upper base layer is formed by doping a fourth part of the substrate layer. Depending on the embodiment, the order of the steps 640 and 650 can be reversed, or the steps 640 and 650 can be performed concurrently or simultaneously. At step 660, a top layer is formed by doping only a part of the upper base layer.

In some embodiments, the method 600 also includes, as optional steps, additional steps that can be performed depending on the type of semiconductor device being fabricated. In the case of the semiconductor device being a thyristor that is of an isolation single-side mesa type, at step 670, a respective moat is formed around the upper base layer of each semiconductor device in the wafer. Alternatively, in the case of the semiconductor device being a thyristor that is of an isolation planar type, at step 670, channel stoppers are formed in the substrate layer of each semiconductor device in the wafer. In a particular embodiment, however, the channel stoppers of the step 670 are formed simultaneously or concurrently with the top layer of the step 660, in a single step.

Regardless of the type of semiconductor device being fabricated, at step 680, a passivation of a respective coating is formed atop each coating region of each semiconductor device, according to one embodiment. In some embodiments, the wafer can be further processed, including forming the terminals including the cathode, anode, and gate, and dicing the wafer to separate the semiconductor devices from the wafer, and so on. Otherwise, after the step 660, 670 or 680, the method 600 terminates.

Advantageously, fabricating a semiconductor device having a tub structure according to the method 600 reduces a thickness of a drift region in a portion of the substrate layer that corresponds to an active region associated with an anode of the semiconductor device. Further, reducing the thickness of the drift region can reduce a peak on-state voltage of the semiconductor device. In this regard, the peak on-state voltage can be reduced without impairing a capability of voltage blocking via the isolation structure of the semiconductor device. The capability of voltage blocking is maintained because although the tub structure is formed in the substrate layer, a sufficient amount of substrate remains in the substrate layer to serve as a depletion region when the semiconductor device is in a state of reverse bias during operation.

Further embodiments are described as follows. One embodiment in particular provides a method of fabricating a semiconductor device in a wafer. The method includes providing a substrate layer. The method also includes providing an isolation structure that laterally isolates the semiconductor device from other semiconductor devices in the wafer. The method also includes forming a tub structure in the substrate layer. The method also includes providing a base layer disposed under the substrate layer. The base layer includes an anode having an associated active region that includes a drift region in the substrate layer. The tub structure is disposed inside the active region such that the presence of the tub structure reduces a thickness of the drift region.

Another embodiment in particular provides a wafer for fabricating semiconductor devices. The wafer includes an isolation structure that laterally isolates the semiconductor devices from one another in the wafer. The wafer also includes a substrate layer for each of the semiconductor devices. The wafer also includes a tub structure for each semiconductor device. The tub structure is formed in the substrate layer. The wafer also includes, for each semiconductor device, a lower base layer disposed below the substrate layer and the tub structure. The lower base layer includes an anode having an associated active region that includes a drift region in the substrate layer. The tub structure is disposed inside the active region such that presence of the tub structure reduces a thickness of the drift region. The wafer also includes an upper base layer disposed above the substrate layer. The wafer also includes a top layer disposed above the upper base layer.

Still another embodiment in particular provides a semiconductor device fabricated in a wafer. The semiconductor device includes a substrate layer. The semiconductor device also includes a tub structure formed in the substrate layer. The semiconductor device also includes a lower base layer disposed below the substrate layer and the tub structure. The lower base layer includes an anode having an associated active region that includes a drift region in the substrate layer. The tub structure is disposed inside the active region such that the tub structure reduces a thickness of the drift region. The semiconductor device also includes an upper base layer disposed above the substrate layer. The semiconductor device also includes a top layer disposed above the upper base layer.

While the present embodiments have been disclosed with reference to certain embodiments, numerous modifications, alterations and changes to the described embodiments are possible without departing from the sphere and scope of the present disclosure, as defined in the appended claims. Accordingly, it is intended that the present embodiments not be limited to the described embodiments, and that it has the full scope defined by the language of the following claims, and equivalents thereof.

## Claims

1. A method of fabricating a semiconductor device in a wafer, the method comprising:
providing a substrate layer;
providing an isolation structure that laterally isolates the semiconductor device from other semiconductor devices in the wafer;
forming a tub structure in the substrate layer; and
providing a base layer disposed under the substrate layer, the base layer including an anode having an associated active region that includes a drift region in the substrate layer, wherein the tub structure is disposed inside the active region such that presence of the tub structure reduces a thickness of the drift region.

2. The method of claim 1, wherein the thickness is reduced relative to a corresponding thickness of the drift region absent the tub structure.

3. The method of claim 1 or 2, wherein the tub structure is formed to reduce a peak on-state voltage (V_{TM}) of the semiconductor device, wherein the peak on-state voltage is reduced without impairing a capability of voltage blocking in the isolation structure when the semiconductor device is in a state of reverse bias.

4. The method of any of the preceding claims, wherein the semiconductor device comprises a thyristor, and wherein the substrate layer comprises silicon.

5. The method of any of the preceding claims, wherein the base layer comprises a lower base layer, and wherein the method further comprises:
providing (i) an upper base layer disposed over the substrate layer and (ii) a top layer disposed over the upper base layer, the upper base layer including a gate, the top layer including a cathode.

6. The method of claim 5, wherein the top layer is smaller in area than the upper base layer, whereby the upper layer is partially exposed, and wherein the substrate layer has a greater thickness than each of the lower base layer, the upper base layer, and the top layer.

7. The method of claim 5 or 6, wherein the lower base layer, the substrate layer, the upper base layer, the top layer, and the isolation structure are of the wafer and are provided by:
forming the isolation structure by doping a first part of the substrate layer;
wherein the tub structure is formed by doping a second part of the substrate layer;
forming the lower base layer by doping a third part of the substrate layer;
forming the upper base layer by doping a fourth part of the substrate layer; and
forming the top layer by doping only a part of the upper base layer.

8. The method of any of the claims 5-7, wherein the lower base layer, the isolation structure, and the upper base layer are of a first polarity type, and wherein the substrate layer and the top layer are of a second polarity type.

9. The method of claim 8, wherein the first polarity type comprises a positive type (P type), and wherein the second polarity type comprises a negative type (N type), or
wherein the first polarity type comprises a negative type (N type), and wherein the second polarity type comprises a positive type (P type).

10. The method of claims 8 or 9, wherein:
the lower base layer comprises a P lower base layer, the isolation structure comprises a P isolation structure, the substrate layer comprises an N⁻ substrate layer, the upper base layer comprises a P upper base layer, and the top layer comprises an N⁺ top layer; or
the lower base layer comprises an N lower base layer, the isolation structure comprises an N isolation structure, the substrate layer comprises a P⁻ substrate layer, the upper base layer comprises a P upper base layer, and the top layer comprises a P⁺ top layer.

11. The method of any of the claims 7-10, wherein the upper base layer of the semiconductor device is smaller in area than the substrate layer of the semiconductor device, whereby the upper base layer of the semiconductor device is partially exposed prior to coating, and wherein the method further comprises:
forming a respective channel stopper in each of a plurality of exposed regions of the upper base layer of the semiconductor device, wherein the respective channel stopper reduces a measure of current leakage by serving as a depletion region in the substrate layer; and
forming, for each of one or more coating regions of the semiconductor device, a passivation of a respective coating atop the respective coating region, wherein the respective coating is selected from a glass coating and a film coating, preferably the one or more coating regions comprising:
a primary region disposed above at least the isolation structure; and
one or more surface regions of the upper base layer of the semiconductor device.

12. The method of any of the claims 7-11, further comprising:
forming a moat around the upper base layer of the semiconductor device to be fabricated, wherein the upper base layer comprises an island region circumscribed by the moat; and
forming, for each of one or more coating regions of the semiconductor device, a passivation of a respective coating atop the respective coating region, wherein the respective coating is selected from a glass coating and a film coating, preferably the one or more coating regions comprising:
the moat; and
one or more surface regions of the upper base layer of the semiconductor device;
wherein prior to the coating being formed, the substrate layer of the semiconductor device is only exposed via the moat.

13. The method of any of the claims 7-12, further comprising:
dicing the semiconductor device to separate the semiconductor device from the wafer.

14. A wafer for fabricating semiconductor devices, the wafer comprising:
an isolation structure that laterally isolates the semiconductor devices from one another in the wafer; and
for each of the semiconductor devices:
a substrate layer;
a tub structure formed in the substrate layer;
a lower base layer disposed below the substrate layer and the tub structure, the lower base layer including an anode having an associated active region that includes a drift region in the substrate layer, wherein the tub structure is disposed inside the active region such that presence of the tub structure reduces a thickness of the drift region;
an upper base layer disposed above the substrate layer; and
a top layer disposed above the upper base layer, preferably
wherein the top layer is smaller in area than the upper base layer, and wherein the substrate layer is greater in thickness than each of the lower base layer, the upper base layer, and the top layer.

15. A semiconductor device fabricated in a wafer, the semiconductor device comprising:
a substrate layer;
a tub structure formed in the substrate layer;
a lower base layer disposed below the substrate layer and the tub structure, the lower base layer including an anode having an associated active region that includes a drift region in the substrate layer, wherein the tub structure is disposed inside the active region such that presence of the tub structure reduces a thickness of the drift region;
an upper base layer disposed above the substrate layer; and
a top layer disposed above the upper base layer, preferably wherein the top layer is smaller in area than the upper base layer, and wherein the substrate layer is greater in thickness than each of the lower base layer, the upper base layer, and the top layer.
